## Europäisches Patentamt

## European Patent Office

## Office européen des brevets

(19)

(11) Publication number: **0 043 199**

**B1**

(12) # EUROPEAN PATENT SPECIFICATION

(45) Date of publication of patent specification: 01.02.84

(51) Int. Cl.³: **H 01 R 13/193**

(21) Application number: **81302633.3**

(22) Date of filing: **15.06.81**

(54) Zero insertion force electrical connector.

(30) Priority: **30.06.80 US 164199**

(43) Date of publication of application:
**06.01.82 Bulletin 82/1**

(45) Publication of the grant of the patent:
**01.02.84 Bulletin 84/5**

(84) Designated Contracting States:
**DE FR GB IT NL**

(56) References cited:
**DE - A - 2 739 645
US - A - 4 054 347**

**IBM TECHNICAL DISCLOSURE BULLETIN, Vol.
22, No. 5, October 1979 New York E. PENACHIO
et al. "Arrangement for Detachably Contacting
Modules and Circuit Boards" page 1936
IBM TECHNICAL DISCLOSURE BULLETIN, Vol.
17, No. 5, October 1974 New York G.E. DOODY
"Cam Activated Multicontact Connector" pages
1275, 1276**

(73) Proprietor: **AMP INCORPORATED
Eisenhower Boulevard
Harrisburg Pennsylvania (US)**

(72) Inventor: **Bright, Edward John
R.D. No. 1, Box 8C
Elizabethtown Pennsylvania 17022 (US)**
Inventor: **Dittmann, Larry Eugene
990 Sherbourne Court
Harrisburg Pennsylvania 17112 (US)**
Inventor: **Webster, Van Keith
785 Erford Road
Camp Hill Pennsylvania 17011 (US)**

(74) Representative: **Gray, Robin Oliver et al,
BARON & WARREN 18 South End Kensington
London W8 5BU (GB)**

Courier Press, Leamington Spa, England.

## Zero insertion force electrical connector

The invention relates to a zero insertion force electrical connector and to a contact for use in the connector.

It is often required to provide an electrical connector having sockets which can be opened to mate with a male contact with zero insertion force and yet which will maintain an effective contact force to establish a satisfactory electrical connection even after repeated mating. As such connector is often required for printed circuit board applications in conjunction with dual-in-line packages it should also be of small size.

A prior electrical connector disclosed in US—A—4,080,032 comprises an insulating housing assembly including a first housing part formed with a series of contact-receiving cavities opening to a first face of the first housing part a series of contacts received in respective cavities, each contact comprising first and second arms integrally joined togther at root ends and having opposed contact surfaces at free ends to define sockets adjacent the first face, the second arm including an intermediate, transversely extending, resilient portion between the free end and the root end, the first arm being fixed in the first housing part and the free end of the second arm being coupled to a second housing part mounted for sliding movement on the first housing part to move the contact surface of the second arm away from the contact surface of the first arm with resilient flexure of the intermediate portion to open the socket and admit a lead with zero insertion force.

However, a disadvantage of the prior connector is that the intermediate portion has only a cantilever beam stress characteristic when fixed with the result that a sufficient contact force to enable satisfactory electrical connection whilst permitting repeated mating cannot be obtained in a connector of small size.

In a connector according to the invention the intermediate portion is of a sinuous shape having successive elements extending longitudinally and laterally of the contact arm so that the intermediate portion has both torsional and bending stress components when flexed.

According to another aspect of the invention, a contact for a zero insertion force connector as described above comprising first and second arms integrally joined together at root ends and having opposed contact surfaces at free ends to define sockets, the second arm including an intermediate, transversely extending, resilient portion, between the free end and the root end is characterised in that the intermediate portion is of sinuous shape, having successive elements extending longitudinally and laterally of the contact arm so that the intermediate portion has both torsional and bending stress components when flexed.

An example of a zero insertion force connector according to the invention and a contact therefor will now be described with reference to the accompanying drawings in which:—

Figure 1 is an exploded perspective view of the connector;

Figure 2 is a perspective view of the connector with a dual-in-line package (DIP) aligned for mating therewith;

Figure 3 is a perspective view of the contact to a larger scale;

Figure 4 is a plan view of a contact blank;

Figures 5, 6 and 7 are partly cross-sectional views of the connector showing the relative disposition of the parts prior, during and after mating with DIP leads;

Figures 8 and 9 are cross-sectional views taken along lines 8—8 and 9—9 of Figures 5 and 6 respectively; and,

Figure 10 is an end view of the connector.

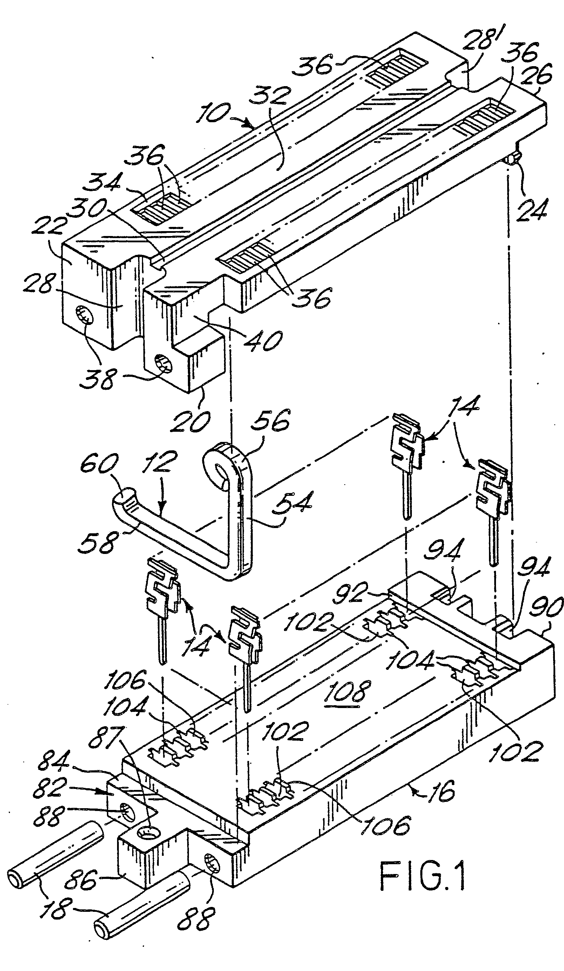

As shown particularly in Figure 1, the electrical connector 11 comprises first, lower and second, upper, housing parts 16 and 10, respectively, an operating lever 12, contacts 14 and guide rods 18.

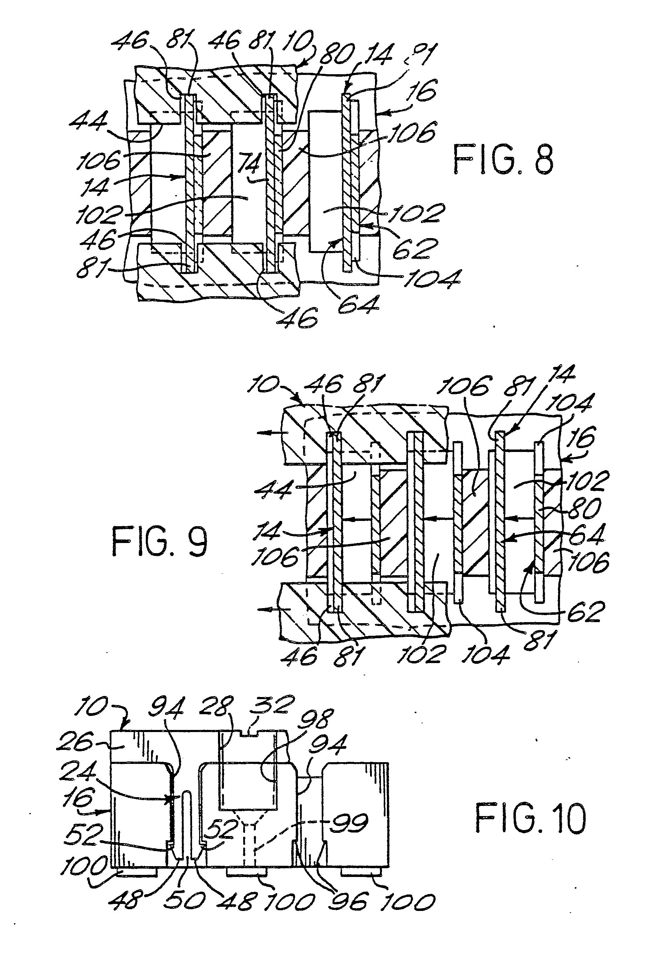

The housing 10 is of substantially L-shape the base defining a vertical abutment wall 20 at a front end 22 while two, slit, locating pins 24 extend downwardly from a rear end 26 (as shown also in Figure 10). Both ends of the upper housing are bisected by U-section, vertical rebates 28, 28' which are intersected by a groove 30 extending medially along an upper face 32. A pair of elongate, parallel recesses 34, extend along the upper face for most of its length on respective opposite sides of the slot and a row of through-apertures 36 are located in respective recesses. A pair of longitudinally extending sockets 38 are formed in the front wall 20, on respective opposite sides of the rebate 28. A recess 40 is formed in one side of wall 20 to provide clearance for lever 12.

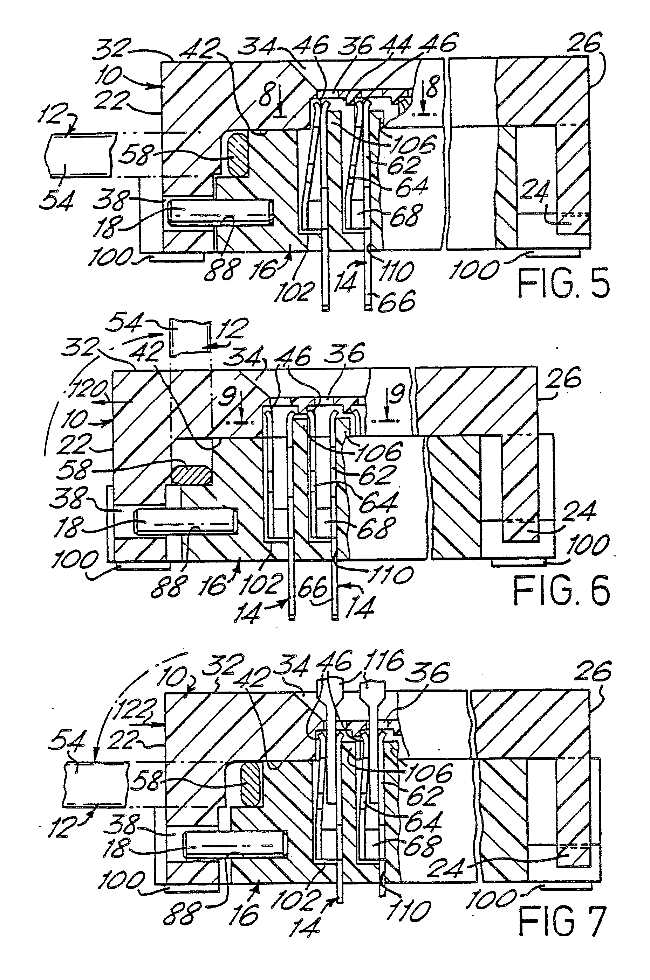

As shown particularly in Figures 5 and 8, a lower face 42 of the housing 10 is formed with a pair of recesses 44 aligned with recesses 34. A row of laterally extending notches 46 are formed in each side wall defining each recess 44, each notch being located below and immediately forward of each aperture 36.

As shown particularly in Figure 10, each slit pin 24 includes two fingers 48 defined by a slot 50, and having bevelled free ends with upwardly facing shoulders 52.

Both lower and upper housings are preferably moulded from a plastics compound, such as polyphenylene sulfide.

The lever 12 is made from a rigid material such as annealed stainless steel wire of rectangular cross-section with rounded corners.

A free end of a first leg 54 of the lever is bent back on itself to form a finger-piece 56. A second leg 58 is bent to extend perpendicularly to the first leg. A free end 60 of the second leg is upset to provide a stop retaining the lever in the housings.

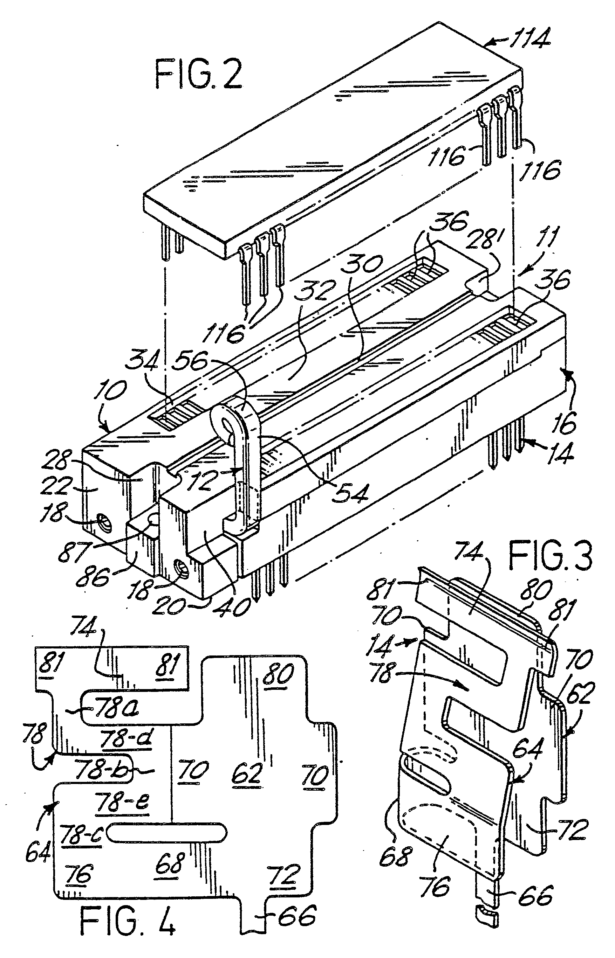

As shown particularly in Figures 3 and 4, the contact member is stamped and formed in one piece from sheet metal, preferably beryllium copper with a tin-lead or gold plating and comprises first and second arms 62 and 64, respectively, integrally joined together at adjacent sides of root end portions 72 and 76 by a strap 68 defining a bight having an axis extending longitudinally of the arms. A solder post 66 extends from the root end portion of the first arm.

Mounting ears 70 extend laterally from respective opposite sides of the first arm 62 which has a rigid, substantially planar body.

The root end portion 76 of the second arm extends laterally and is integrally joined to a laterally extending free end portion 74 by an intermediate portion 78. The intermediate portion has three longitudinally extending elements 78a, 78b and 78c joined together by two laterally extending elements 78d and 78e. The longitudinal and lateral elements are joined successively to define an intermediate portion of sinuous shape.

Tab portions 81 extend laterally from respective opposite sides of the free end portion 74 beyond the free end portion 80 of the first arm.

As shown in Figure 3, whilst the root end portions of the two arms are parallel the remainder of the second arm 64, is prestressed (preferably before forming the strap 68) so that the free end portion 74 presses against free end portion 80, preloading the second arm. The free end portions 74 and 80 provide opposed contact surfaces defining a socket.

The lower housing 16 is of rectangular shape with substantially the same width and length as the upper housing 10. A laterally extending ledge 84 is formed in a front end 82 of the lower housing and a mounting foot 86 extends forwardly from the ledge and is formed with a socket 87 for a mounting bolt (not shown). Sockets 88, for receiving the guide rods 18 are formed on the front end on respective opposite sides of the foot 86.

As shown in Figure 10, two vertically extending through-slots 94 are formed in a back end 90 of the lower housing 16 and are counterbored adjacent their lower ends to provide downwardly facing shoulders 96. A recess 98 is formed in an upper face between the through slots and extends to a socket 99 for receiving a mounting screw or bolt.

As shown in Figure 5, feet 100 extend from the lower housing face at the front and rear to space the housing from the surface of a printed circuit board (not shown).

As shown in Figure 1, two rows of cavities 102 are formed in the lower housing at the same pitch as the apertures 34. The cavities are of rectangular shape and have slots 104 extending laterally adjacent a back wall which projects above upper face 108 to provide a rib 106.

A pin receiving bore 110 extends from each cavity.

The connector 11 is intended for repeated mating with a conventional DIP 114 having leads 116 for insertion into respective contacts.

To assemble the connector, the contacts 14 are loaded into respective cavities 102 with ears 70 received in slots 104 to fix the first arm in the lower housing against horizontal movement. The free end portion 80 rests against rib 106 as shown in Figure 5 and pin 66 extends through bore 110 for insertion into a printed circuit board. The free end portion 74 of the second arm 64 also extends above upper face 108 of the lower housing.

The second leg 58 of lever 12 is then located on the ledge 84 and the lever held with the first leg horizontal, as shown in Figure 5, while the upper housing 10 is positioned on top of the lower housing. The split pins 24 are pushed through the slots 94 so that the upwardly facing shoulders 52 snap under downwardly facing shoulders 96, as the wall 20 of the upper housing 10 slides down the front end 82 of the lower housing. Rods 18 are inserted into the aligned sockets 38 and 88 and received as an interference fit in the latter and a free sliding flit in the former. Contact tabs 81 are received in notches 46, as shown in Figures 8 and 9. The connector 11 may then be plugged into a PCB and retained thereon by the mounting screws.

As shown in Figures 5 to 9, in operation of the connector, the level 12 is rotated from the position of Figure 5 to the position of Figure 6 displacing upper housing 10 in the direction of arrow 120 by a distance equal to the width of lever leg 58. Engagement between the tabs 81 and the walls of the notches 96 causes the upper housing to flex the second arms 64 away from first arms 62 moving the contact surfaces on the second arms away from the contact surfaces of the first arms to open the sockets. In addition, the displacement of the upper housing brings apertures 36 from the misaligned position of Figures 5 and 8 into alignment with the cavities and the sockets as shown in Figures 6 and 9.

After inserting leads 116 of DIP 114 through apertures 36 into the sockets the lever 12 is rotated back to the horizontal position shown in Figure 5, permitting the upper housing 10 to be moved back in the direction of arrow 122 by the combined spring forces of the second arms 64.

The resultant contact force acting on the DIP lead is a function of both the particular spring characteristic plus the preload forces. As is well known, the parameters which must be considered when designing a contact spring include the desired resultant contact force, the distance the spring can be deflected, the maximum deflection force available, a factor which may be limited by housing materials and dimensions, spring material and available space, particularly laterally of the deflection direction. In the connector of the invention, the physical space available is necessarily small in view of the close spacing of DIP leads and the housing material and construction severely limited the overall contact member size and its first and second arms. The second arm structure has a torsion spring characteristic which is advantageous when compared with a conventional cantilever beam-type spring characteristic where most of the force is concentrated at the point of bending. As the second arms are pulled away from the first arms, the elements of the second arms both bend and twist. Even though the total deflections of the second arms are not great, the combined torsional and bending stresses provide a considerable amount of spring force in addition to the preloading or prestressing force.

On releasing the second arms to engage the leads the resultant spring contact force is substantially constant but the components of forces; i.e. torsion and bending, contributed by the longitudinally and laterally extending elements vary depending on the lateral displacement of the lead from a central position, as shown in the table below. The left and right of centre positions are in line with the respective longitudinally extending elements with reference to Figure 4.

POSITION OF LEAD

| Second Arm Elements | Centre | Left | Right |
|---|---|---|---|
| 74 | zero torsion minor bending | zero torsion zero bending | zero torsion bending increases |
| 78a | torsion bending | zero torsion bending is constant | torsion increases bending is constant |
| 78d | torsion very minor bending | torsion increases bending increases | torsion is constant bending increases |
| 78b | torsion bending | torsion increases bending is constant | zero torsion bending is constant |
| 78e | torsion very minor bending | minor torsion zero bending | torsion is constant bending increases |
| 78c | torsion bending | zero torsion bending is constant | torsion increases bending is constant |
| 76 76 68 | torsion very minor bending | torsion increases bending increases | torsion decreases bending decreases |

The forces change linearly on displacement of the lead laterally of the contact.

The structure of the second spring arm enables both prestressing to be accommodated to enable a sufficiently high contact force to be obtained and repeated flexure to open the socket as would be required in a DIP test socket.

## Claims

1. A zero insertion force electrical connector (11) comprising a insulating housing assembly (10, 16) including a first housing part (16) formed with a series of contact-receiving cavities (102) opening to a first face (108) of the first housing part (16), a series of contacts (14) received in respective cavities (102), each contact (14) comprising first and second arms (62 and 64) integrally joined together at root ends (72 and 76) and having opposed contact surfaces at free ends (80, 74) to define sockets adjacent the first face (108), the second arm (64) including an intermediate, transversely extending, resilient portion (78), between the free end (74) and the root end (76), the first arm (62) being fixed in the first housing part (16) and the free end (74) of the second arm (64) being coupled to a second housing part (10) mounted for sliding movement on the first housing part (16) to move the contact surface of the second arm (64) away from the contact surface of the first arm (62) with resilient flexure of the intermediate portion (78) to open the socket and admit a lead (116) with zero insertion force, characterised in that the intermediate portion (78) is of sinuous shape, having successive elements (78a, d, b, e, c) extending longitudinally and laterally of the contact arm (64) so that the intermediate portion (78) has both torsional and bending stress components when flexed.

2. A zero insertion force connector according to Claim 1 characterised in that the contact arms (62 and 64) are integrally joined together at their root ends (72 and 76) by a bight (68) having an axis extending longitudinally of the contact arms (62 and 64).

3. A zero insertion force connector according to Claim 1 or Claim 2, characterised in that tabs (81) extend laterally from respective opposite sides of the free ends (74) of the second arms (64) laterally beyond the free ends (80) of the respective first arms (62) and are received in notches (46) formed in the second housing part (10) adjacent the respective cavities (102).

4. A zero insertion force connector according to any one of the preceding claims, characterised in that the first arm (62) is substantially planar and is formed with laterally extending ears (70) received in slots (104) formed in the first housing part (16) to fix the first arm (62) in the first housing part (16).

5. A zero insertion force connector according to any one of the preceding claims, characterised in that the second housing part (10) is mounted for sliding movement on the first face (108) of the first housing part (16) and is formed with a series of apertures (36) brought into alignment with respective cavities (102) on movement of the second housing part (10) to open the sockets.

6. A zero insertion force connector according to any one of the preceding claims, characterised in that the second contact arm (64) is prestressed against the first contact arm.

7. A contact for a zero insertion force connector (11) according to Claim 1, comprising first and second arms (62 and 64) integrally joined together at rood ends (72 and 76) and having opposed contact surfaces at free ends (80, 74) to define sockets, the second arm (64) including an intermediate, transversely extending resilient portion (78) between the free end (74) and the root end (76), characterised in that the intermediate portion (78) is of sinuous shape, having successive elements (78a, d, b, e, c) extending longitudinally and laterally of the contact arm (64) so that the intermediate portion (78) has both torsional and bending stress components when flexed.

8. A contact according to Claim 7 characterised in that the second contact arm (64) is prestressed against the first contact arm (62).

## Patentansprüche

1. Elektrischer Steckverbinder (11) mit einer Einsteckkraft gleich Null, mit einer isolierenden Gehäuseanordnung (10, 16), die einen ersten Gehäuseteil (16) aufweist, welcher mit einer Reihe von Kontakt aufnehmenden Hohlräumen (102) versehen ist, welche sich zu einer ersten Fläche (108) der ersten Gehäuseteils (16) öffnen, einer Reihe von Kontakten (14), die in jeweiligen Hohlräumen (102) aufgenommen sind, wobei jeder Kontakt (14) erste und zweite Arme (62, 64) umfaßt, die einstückig miteinander an Wurzelenden (72 und 76) verbunden sind un gegenüberliegende Kontaktflächen an freien Enden (80, 74) aufweisen, um Sockel in der Nähe der ersten Fläche (108) zu bilden, wobei ferner der zweite Arm (64) einen mittleren, sich quer erstreckenden, elastischen Abschnitt (78) zwischen dem freien Ende (74) und dem Wurzelende (76) aufweist, der erste Arm (62) in dem ersten Gehäuseteil (16) festgelegt ist und das freie Ende (74) des zweiten Arms (64) mit einem zweiten Gehäuseteil (10) gekoppelt ist, der für eine gleitende Bewegung an dem ersten Gehäuseteil (16) angebracht ist, um die Kontaktfläche des zweiten Arms (64) von der Kontaktfläche des ersten Arms (62) unter elastischer Beigung des mittleren Abschnitts (78) weg zu bewegen, so daß der Sockel geöffnet wird und ein Anschluß (116) mit einer Einsetzkraft gleich Null eingelassen wird, dadurch gekennzeichnet, daß der mittlere Abschnitt (78) eine sinusförmige Gestalt aufweist und aufeinanderfolgende Elemente (78a, d, b, e, c) umfaßt, die sich in Längsrichtung und seitlich zum Kontaktarm (64) erstrecken, so daß der mittlere Abschnitt (78) beim Biegen sowohl Torsionsspannungskomponenten als auch Biegespannungskomponenten aufweist.

2. Steckverbinder mit einer Einsteckkraft gleich Null nach Anspruch 1, dadurch gekennzeichnet, daß die Kontaktarme (62 und 64) an ihren Wurzelenden (72 und 76) einstückig durch eine Schleife (68) miteinander verbunden sind, deren Achse sich in Längsrichtung der Kontaktarme (62 und 64) erstreckt.

3. Steckverbinder mit einer Einsteckkraft gleich Null nach Anspruch 1 oder 2, dadurch gekennzeichnet, daß Laschen (81) sich seitlich von jeweils gegenüberliegenden Seiten der freien Enden (74) der zweiten Arme (64) weg erstrekken, und zwar seitlich über die freien Enden (80) der jeweiligen ersten Arme (62) hinaus, und in Kerben (46) aufgenommen sind, die in dem zweiten Gehäuseteil (10) in der Nähe der jeweiligen Hohlräume (102) geformt sind.

4. Steckverbinder mit einer Einsteckkraft gleich Null nach einem der vorhergehenden Ansprüche, dadurch gekennzeichnet, daß der erste Arm (62) im wesentlichen eben ist und mit sich seitlich erstreckenden Ohren (70) versehen ist, die in Schlitzen (104) aufgenommen sind, welche in dem ersten Gehäuseteil (16) geformt sind, um den ersten Arm (2) in dem ersten Gehäuseteil (16) festzulegen.

5. Steckverbinder mit einer Einsteckkraft gleich Null nach einem der vorhergehenden Ansprüche, dadurch gekennzeichnet, daß der zweite Gehäuseteil (10) zur gleitenden Bewegung auf der ersten Fläche (108) des ersten Gehäuseteils (16) angebracht ist und mit einer Reihe von Öffnungen (36) versehen ist, die bei Bewegung des zweiten Gehäuseteils (10) zur Öffnung der Sockel in Ausrichtung mit entsprechenden Hohlräumen (102) gebracht werden.

6. Steckverbinder mit einer Einsteckkraft gleich Null nach einem der vorhergehenden Ansprüche, dadurch gekennzeichnet, daß der zweite Kontaktarm (64) gegen den ersten Kontaktarm vorgespannt ist.

7. Kontakt für einen Steckverbinder (11) mit einer Einsteckkraft gleich Null nach Anspruch 1, mit ersten und zweiten Armen (62 und 64), die an Wurzelenden (72 und 76) einstückig miteinander verbunden sind und gegenüberliegende Kontaktflächen an freien Enden (80, 74) zur Begrenzung von Sockeln aufweisen, wobei der zweite Arm (64) einen mittleren, sich quer erstreckenden elastischen Abschnitt (78) zwischen dem freien Ende (74) und dem Wurzelende (76) aufweist, dadurch gekennzeichnet, daß der mittlere Abschnit (78) eine sinusförmige Gestalt aufweist und aufeinanderfolgende Elemente (70a, d, b, e, c) umfaßt, die sich in Längsrichtung und seitlich zum Kontaktarm (64) erstrecken, so daß der mittlere Abschnitt (78) beim Biegen sowohl Torsionsspannungskomponenten als auch Biegespannungskomponenten aufweist.

8. Kontakt nach Anspruch 7, dadurch gekennzeichnet, daß der zweite Kontaktarm (64) gegen den ersten Kontaktarm (62) vorgespannt ist.

**Revendications**

1. Connecteur électrique (11) à force d'insertion nulle comprenant un ensemble à boîtier isolant (10, 16) comportant une première partie (16) de boîtier qui présente une série de cavités (102) de réception de contacts s'ouvrant à une première face (108) de la première partie (16) de boîtier, un série de contacts (14) reçus dans des cavités respectives (102), chaque contact (14) comprenant des première et seconde lames (62 et 64) reliées intégralement entre elles, à leurs extrémités de pieds (72 et 76), et ayant des surfaces de contact opposées à des extrémités libres (80, 74) pour définir des douilles adjacentes à la première face (108), la seconde lame (64) comprenant une partie intermédiaire élastique (78) s'étendant transversalement, entre l'extrémité libre (74) et l'extrémité de pied (76), la première lame (62) étant fixée dans la première partie (16) du boîtier et l'extrémité libre (74) de la seconde lame (64) étant reliée à une seconde partie (10) de boîtier montée afin de pouvoir glisser sur la première partie (16) de boîtier pour éloigner la surface de contact de la seconde lame (64) de la surface de contact de la première lame (62), avec une flexion élastique de la partie intermédiaire (78), afin d'ouvrir la douille et d'introduire un conducteur (116) sous une force d'insertion nulle, caractérisé en ce que la partie intermédiaire (78) est de forme sinueuse, comportant des éléments successifs (78a, d, b, e, c) s'étendant longitudinalement et latéralement à la lame (64) de contact afin que la partie intermédiaire (78) présente, lorsqu'elle est fléchie, des composantes d'effort à la fois de torsion et de flexion.

2. Connecteur à force d'insertion nulle selon la revendication 1, caractérisé en ce que les lames de contact (62 et 64) sont reliées intégralement entre elles, à leurs extrémités de pieds (72 et 76), par un coude (68) ayant un axe s'étendant longitudinalement aux lames de contact (62 et 64).

3. Connecteur à force d'insertion nulle selon la revendication 1 ou la revendication 2, caractérisé en ce que des pattes (81) partent latéralement de côtés opposés respectifs des extrémités libres (74) des secondes lames (64), latéralement au-delà des extrémités libres (80) des premières lames respectives (62), et sont reçues dans des entailles (46) formées dans la seconde partie (10) de boîtier à proximité immédiate des cavités respectives (102).

4. Connecteur à force d'insertion nulle selon l'une quelconque des revendications précédentes, caractérisé en ce que la première lame (62) est sensiblement plane et est formée avec des oreilles (70) s'étendant latéralement, reçues dans des rainures (104) formées dans la première partie (16) du boîtier afin de fixer la première lame (62) dans la première partie (16) du boîtier.

5. Connecteur à force d'insertion nulle selon l'une quelconque des revendications précédentes, caractérisé en ce que la seconde partie (10) du boîtier est montée de façon à pouvoir coulisser sur la première face (108) de la première partie (16) du boîtier et est formée avec une série d'ouvertures (35) amenées en alignement avec des cavités respectives (102) lors d'un mouvement de la seconde partie (10) de boîtier pour ouvrir les douilles.

6. Connecteur à force d'insertion nulle selon l'une quelconque des revendications précédentes, caractérisé en ce que la seconde lame (64) de contact est précontrainte contre la première lame de contact.

7. Contact pour un connecteur (11) à force d'insertion nulle selon la revendication 1, comprenant des première et seconde lames (62 et 64) reliées intégralement entre elles, à des extrémités de pieds (72 et 76), et ayant des surfaces de contact opposées à des extrémités libres (80, 74) pour définir des douilles, la seconde lame (74) comprenant une partie intermédiaire élastique (78) s'étendant transversalement entre l'extrémité libre (74) et l'extrémité de pied (76), caractérisé en ce que la partie intermédiaire (78) est de forme sinueuse, ayant des éléments successifs (70a, d, b, e, c) s'étendant longitudinalement et latéralement à la lame de contact (64) afin que la partie intermédiaire (78) présente, lorsqu'elle est fléchie, des composantes d'effort à la fois de torsion et de flexion.

8. Contact selon la revendication 7, caractérisé en ce que la seconde lame (64) de contact est précontrainte contre la première lame (62) de contact.

FIG.1

FIG. 2

FIG. 3

FIG. 4

FIG. 5

FIG. 6

FIG 7

3

FIG. 8

FIG. 9

FIG. 10